**Europäisches Patentamt**

**European Patent Office**

**Office européen des brevets**

(19)

(11) Veröffentlichungsnummer: **0 000 480 B1**

(12) **EUROPÄISCHE PATENTSCHRIFT**

(45) Veröffentlichungstag der Patentschrift: **12.08.81**

(21) Anmeldenummer: **78100268.8**

(22) Anmeldetag: **28.06.78**

(51) Int. Cl.³: **H 01 L 21/56** //H01L23/28

(54) **Verfahren zum Passivieren von Halbleiterelementen durch Aufbringen einer Siliciumschicht.**

(30) Priorität: **05.07.77 DE 2730367**

(43) Veröffentlichungstag der Anmeldung:
**07.02.79 Patentblatt 79/3**

(45) Bekanntmachung des Hinweises auf die Patenterteilung:
**12.08.81 Patentblatt 81/32**

(84) Benannte Vertragsstaaten:
**CH FR SE**

(56) Entgegenhaltungen:
**DE - A - 2 618 733**
**DE - A - 2 642 413**
**FR - A - 2 290 040**
**FR - A - 2 359 510**
**NL - A - 76 13893**

(73) Patentinhaber: **SIEMENS AKTIENGESELLSCHAFT**
**Berlin und München**
**Postfach 22 02 61**
**D-8000 München 22 (DE)**

(72) Erfinder: **Krausse, Jürgen**
**Weidenstrasse 12**
**D-8011 Baldham (DE)**
Erfinder: **Ladenhauf, Wilhelm**
**Adenauer Strasse 20**
**D-8031 Puchheim (DE)**

Courier Press, Leamington Spa, England.

## Verfahren zum Passivieren von Halbleiterelementen durch Aufbringen einer Siliciumschicht

Ein wesentliches Problem bei Halbleiterbauelementen besteht darin, die Strom-Spannungskennlinien stabil zu halten. Bei Gleichrichtern und Transistoren sind dies insbesondere die Kennlinien in Sperrichtung, während bei Thyristoren das Augenmerk auf die Stabilität der Kennlinien in Sperrichtung und in Kipprichtung zu lenken ist.

Es sind bereits Verfahren beschrieben worden, durch die ein Halbleiterelement mittels einer thermisch aufwachsenden Siliciumschicht passiviert wird (vergleiche NL-A-7613893, DE-A-26 18 733, FR-A-2 290 040). Die dort beschriebenen Passivierungsverfahren benutzen die bekannte thermische Zersetzung einer gasförmigen Siliciumverbindung, um polykristallines Silicium auf der Oberfläche des Halbleiterelements abzuscheiden. Diese Verfahren erfordern daher Temperaturen zwischen 600 und 700°C, was eine Anwendung bei bereits kontaktierten und eventuell verlöteten Bauelementen unmöglich macht. Das Silicium muß außerdem an denjenigen Stellen, an denen es nicht benötigt wird, weggeätzt werden. Weiter kann dieses Verfahren zu einer starken Herabsetzung der Trägerlebensdauer im Volumen und an der Oberfläche führen.

In der DE-B-1 185 896 ist ein Passivierungsverfahren beschrieben worden, bei dem Silicium im Hockvakuum auf die Oberfläche eines Halbleiterelements aufgedampft wird. Das Aufdampfen kann bei vergleichsweise niedrigeren Temperaturen als bei der thermischen Zersetzung einer Siliciumverbindung durchgeführt werden. Damit ist eine Passivierung von bereits kontaktierten und montierten Bauelementen möglich.

Die Erfindung bezieht sich demnach auf ein Verfahren zum Passivieren von Halbleiterbauelementen, bei dem auf die Oberfläche der Halbleiterelemente im Hochvakuum eine Siliciumschicht aufgedampft wird.

Bei der Kennlinienmessung solcher Art passivierter Halbleiterbauelemente wurde herausgefunden, daß die Kennlinien zwar stabil sind, daß die Sperrströme jedoch viel zu hoch liegen.

Der Erfindung liegt daher die Aufgabe zugrunde, dieses Passivierungsverfahren so weiterzubilden, daß niedrige Sperrströme erzielt werden können.

Die Erfindung ist dadurch gekennzeichnet, daß die aufgedampfte Siliciumschicht bei einer derartigen zwischen der Raumtemperatur und der Kristallisationtemperatur des aufgedampften Siliciums liegenden Temperatur getempert wird, daß eine gewünschte Absenkung der Sperrströme erreicht wird.

Weiterbildungen der Erfindung sind Gegenstand der Unteransprüche.

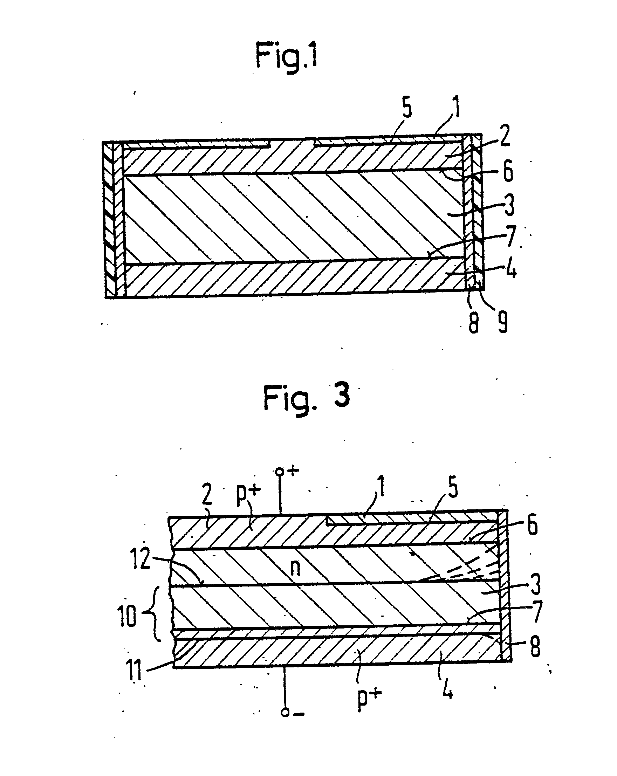

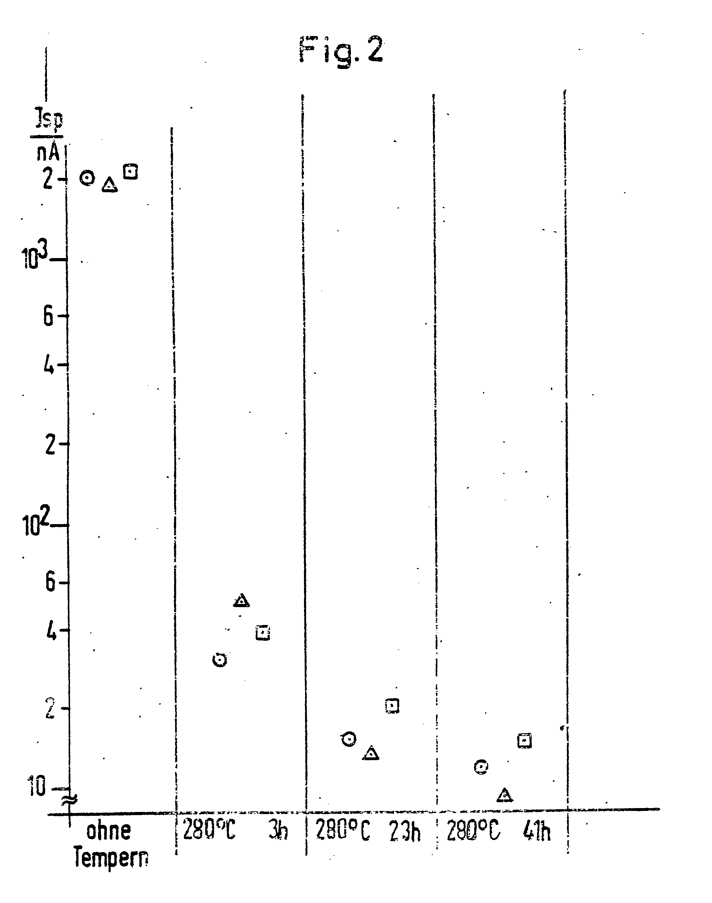

Die Erfindung wird an Hand eines Ausführungsbeispiels in Verbindung mit den Fig. 1 und 3 und an Hand eines Diagramms (Fig. 2) näher erläutert:

In Fig. 1 ist das Halbleiterelement eines Thyristors im Schnitt dargestellt. Es hat vier Zonen, von denen die kathodenseitige Emitterzone mit 1, die kathodenseitige Basiszone mit 2, die innere Basiszone mit 3 und die anodenseitige Emitterzone mit 4 bezeichnet ist. Zwischen den genannten Zonen liegen pn-Übergänge 5, 6, 7. Das Halbleiterelement besteht aus Silicium und die genannten Zonen sind in üblicher Weise je nach Verwendungszweck des Halbleiterbauelements dotiert.

Auf den Rand des Halbleiterelements wird wenigstens and den Stellen, an denen die pn-Übergänge an die Oberfläche treten, eine Schutzschicht 8 aus Silicium aufgedampft, die beispielsweise 0.1 $\mu$m oder auch dicker sein kann, beispielsweise 1 $\mu$m. Die nicht zu bedampfenden Flächen des Halbleiterelements werden vor dem Bedampfen abgedeckt. Zur Erhöhung der dielektrischen Überschlagsfestigkeit und zur Verbesserung des mechanischen Schutzes kann auf die aufgedampfte Siliciumschicht 8 eine weitere Schutzschicht 9 aufgebracht werden, die beispielsweise aus normalem Kautschuk oder einem anderen Schutzlack bestehen kann.

Die aufgedampfte Siliciumschicht 8 kann zur Einstellung des spezifischen Widerstands Dotierstoffe wie zum Beispiel Bor oder Phosphor enthalten. Einen Gehalt an den genannten Dotierstoffen erhölt man dadurch, daß mit dem Silicium einer oder mehrere dieser Stoffe verdampft werden. Die Schicht 8 kann zur Einstellung des spezifischen Widerstands auch ein oder mehrere Metalle wie zum Beispiel Aluminium enthalten. Die Metalle können ebenfalls durch Aufdampfen mit dem Silicium in dieses eingebaut werden. Mit Änderung des spezifischen Widerstands der Schicht 8 lassen sich die Potentialverhältnisse am Rand des Halbleiterelements einstellen. So kann die Schicht 8 beispielsweise mit Phosphor dotiert sein und einen spezifischen Widerstand von $10^8$ Ohm cm haben.

Die Siliciumschicht 8 wurde in einer Vakuum-Bedampfungsanlage bei einem Druck von c.a. $6{,}5 \cdot 10^{-4}$ Pa ($5 \cdot 10^{-6}$ Torr) aufgedampft. Als Siliciumquelle kann beispielsweise ein Siliciumblock verwendet werden. Das Silicium kann mittels eines Elektronenstrahls verdampft werden. Mit einer Beschleunigungsspannung von 8 kV und einem Strom von rund 0,5 A wurde eine Aufdampfrate von 0,25 $\mu$m/min erzielt. Sie läßt sich durch Erhöhung der Energie des Elektronenstrahls auch beispielsweise auf 0,5 $\mu$m/min und darüber steigern.

Das Silicium kann auch durch einen Ionenstrahl, durch direkten Stromdurchfluß oder durch induktive Erhitzung verdampft werden. Es ist auch möglich, das Silicium durch Strahlungswärme zu verdampfen.

Die Schicht 8 kann auch aus mehreren nacheinander aufgedampften Schichten mit jeweils verschiedenen Eigenschaften bestehen. Damit erhält man eine Änderung des spezifischen Widerstands über die Dicke und eine Beeinflussung der Potentialverhältnisse an der Randfläche des Halbleiterelements.

Anschließend an das Bedampfen des Halbleiterelements wird die aufgedampfte Siliciumschicht getempert. Das Tempern findet bei einer Temperatur zwischen Zimmertemperatur und der Kristallisationstemperatur des Siliciums statt. Die Kristallisationstemperatur des Siliciums liegt nach Literaturangaben zwischen 427—627°C (700 und 900°K). Bei bereits kontaktierten Halbleiterelementen wird das Tempern bei einer Temperatur vorgenommen, die unterhalb der Schmelztemperatur des zum Kontaktieren verwendeten Materials, zum Beispiel Weichlot, oder einer anderen Metallisierung liegt. Durch das Tempern lassen sich der Sperrstrom in Sperrichtung und der Sperrstrom in Kipprichtung des Halbleiterelements drastisch absenken. In Fig. 2 ist dargestellt, daß der Sperrstrom Isp bei einem bestimmten Halbleitertyp ohne das Tempern bei $2 \cdot 10^3$ nA lag. Nach einer Temperzeit von drei Stunden bei 280°C lag der Sperrstrom für drei Meßexemplare zwischen 3 und $5 \cdot 10^1$ nA. Nach 23 und 41 Stunden Temperzeit bei 280°C wurden weitere Absenkungen der Sperrströme beobachtet.

Das Aufdampfen des Siliciums selbst kann bei Zimmertemperatur durchgeführt werden. Die Temperatur der anschließenden Wärmebehandlung kann dann so gewählt werden, daß die gewünschte Absenkung der Sperrströme erreicht wird, ohne daß zum Beispiel bereits kontaktierte Bauelemente in Mitleidenschaft gezogen werden. Damit ist es möglich, bereits aufgelötete und kontaktierte Chips zu passivieren, so daß keine Maskierung oder kein selektives Ätzen der Chips erforderlich ist.

Halbleiterelemente, die durch Aufdampfen einer Siliciumschicht und nachfolgendes Tempern passiviert wurden, wiesen eine überraschend gute Stabilität der Kennlinien bei niedrigem Stromniveau auf. Dies galt sowohl für die Sperrkennlinien in Rückwärtsrichtung bei Dioden und Transistoren als auch für die Sperrkennlinien in Rückwärtsrichtung und Kipprichtung bei Thyristoren. Bei Thyristoren trat auch der sogenannte Yoshida-Effekt nicht mehr auf, der eine drastische Erhöhung der Sperrströme nach vorhergehender Durchlaßbelastung bewirkt.

Die Stabilität der Kennlinien läßt sich anschaulich an Hand der Fig. 3 erklären, in der die Gestalt der Raumladungszone dargestellt ist, wenn der pn-Übergang 7 in Sperrichtung beansprucht ist. Zu Anfang der Sperrbelastung verlaufen die Grenzen 11, 12 der Raumladungszone 10 zum Beispiel parallel zu den pn-Übergängen. Liegt längere Zeit Sperrbelastung an, so weitet sich die Raumladungszone dadurch auf, daß sich die Grenze 12 der Raumladungszone 10 am Rand des Halbleiterelement in Richtung auf den pn-Übergang 6 verschiebt. Gleichzeitig entfernt sich die Grenze 11 der Raumladungszone 10 vom pn-Übergang 7, jedoch nur in erheblich schwächerem Maße, da die Zone 4 stärker als die Zone 3 dotiert ist. Die Aufweitung der Raumladungszone ist in der Fig. gestrichelt dargestellt. Mit größer werdender Aufweitung der Raumladungszone nimmt der Sperrstrom zu, bis mit Erreichen des pn-Übergangs 6 am Rand der sogenannte Punch-Through-Effekt eintritt, wo der pn-Übergang 7 seine Sperrfähigkeit verliert. Die Aufweitung findet auch am pn-Übergang 6 statt, wenn das Halbleiterelement in der umgekehrten Richtung, das heißt der Kipprichtung, mit einer Spannung belastet wird.

Mit der Passivierungsschicht gemäß der Erfindung weitet sich die Raumladungszone 10 am Rand nicht mehr auf. Dies läßt sich beispielsweise mit der bekannten lichtelektrischen Methode zur Untersuchung der Raumladungszonen am Rand eines Halbleiterelements feststellen. Dies bedeutet, daß sich die Sperrströme nicht erhöhen, mit anderen Worten, daß die Kennlinien in Sperrichtung stabil bleiben.

Die Erfindung wurde in Verbindung mit einem Halbleiterelement für einen Thyristor beschrieben. Sie läßt sich jedoch auch bei Dioden, Transistoren und anderen Halbleiterbauelementen verwenden. Sie ist gleichermaßen für Mesa- oder Planarstrukturen verwendbar. Wesentlich ist, daß auf mindestens denjenigen Bereich, in dem die pn-Übergänge an die Oberfläche des Halbleiterelements treten, Silicium aufgedampft wird.

## Patentansprüche

1. Verfahren zum Passivieren von Halbleiterbauelementen, bei dem auf die Oberfläche der Halbleiterelemente im Hachvakuum eine Siliciumschicht (8) aufgedampft wird, dadurch gekennzeichnet, daß die aufgedampfte Siliciumschicht (8) bei einer derartigen zwischen der Raumtemperatur und der Kristallisationstemperatur des aufgedampften Siliciums liegenden Temperatur getempert wird, daß eine gewünschte Absenkung der Sperrströme erreicht wird.

2. Verfahren nach Anspruch 1 dadurch gekennzeichnt, daß die Schicht (8) bei Temperaturen getempert wird, die unterhalb der Schmelztemperatur einer auf das Halbleiterelement aufgebrachten Metallisierung liegen.

3. Verfahren nach Ansprüche 1 oder 2, dadurch gekennzeichnt, daß in sauerstoffhaltiger Atmosphäre getempert wird.

**Revendications**

1. Procédé pour passiver des composants à semiconducteurs, selon lequel on dépose par évaporation sous vide poussé une couche de silicium (8) à la surface des éléments semiconducteurs, caractérisé par le fait que la couche de silicium (8) déposé par évaporation est soumise à une recuit à une température située entre la température ambiante et la température de cristallistion du silicium déposé par évaporation et qui est telle que l'on obtient une réduction souhaitée des courants inverses.

2. Procédé selon la revendication 1, caractérisé par le fait que la couche (8) est soumise à un recuit à des températures qui sont inférieures à la température de fusion d'une métallisation déposée sur l'élément semiconducteur.

3. Procédé selon la revendication 1 ou 2, caractérisé par le fait qu'on effectue le recruit dans une atmosphère contenant de l'oxygène.

**Claims**

1. A process for the passivation of semiconductor components, wherein a silicon layer (8) is vapour-deposited on the surface of the semiconductor elements under high vacuum, characterised in that the vapour-deposited silicon layer (8) is annealed at a temperature which lies between room temperature and the crystallization temperature of the vapour-deposited silicon, such that a desired reduction of the reverse currents is achieved.

2. A process as claimed in Claim 1, characterized in that the layer (8) is annealed at a temperature which lies below the melting point of a metallization applied to the semiconductor element.

3. A process as claimed in Claim 1 or Claim 2, characterised in that annealing is effected in an oxygen-containing atmosphere.

# Fig.1

# Fig. 3

# Fig. 2